# EUROPEAN PATENT SPECIFICATION

(11) **EP 0 456 380 B1**
(45) Date of publication and mention of the grant of the patent: **10.07.1996**
(21) Application number: 91303732.1
(22) Date of filing: 25.04.1991
(51) Int. Cl.: C08F 299/00, C08C 19/36, G03F 7/033

(54) **Photocurable composition comprising maleic anhydride adduct of polybutadiene or butadiene copolydiene copolymers**
Photohärtbare Zusammensetzung mit Copolymeren bestehend aus einem Maleinsäure-Anhydrid-Addukt von Polybutadien oder von Butadiencopolydien
Composition photodurcissable à base de copolymères consistant en un adduit de l'anhydride maléique avec du polybutadiène ou avec un copolydiène du butadiène

(30) Priority: 26.04.1990 US 514899; 22.03.1991 US 671937
(43) Date of publication of application: 13.11.1991
(73) Proprietor: PT Sub, Inc., Wilmington, Delaware 19805 (US)
(72) Inventor: Berrier, Arthur Leroy, Ellicott City, Maryland 21043 (US); Kumpfmiller, Ronald James, Waltham, Massachusetts 02154 (US)
(74) Representative: Bentham, Stephen

(56) References cited:
- DE-A- 2 632 010
- US-A- 4 916 045

## Description

### Field of the Invention

This invention relates to radiation curable prepolymers and formulations or compositions containing the same, as well as radiation sensitive articles having solid layers prepared from such prepolymers or formulations. The invention also relates to processes for making and using the prepolymer or composition to form the radiation sensitive articles.

### Background of the Invention

Photocurable prepolymers and compositions are well known in the art for forming printing plates and other radiation sensitive articles. In the field of flexographic printing plates, the plates typically comprise a support and a photosensitive layer prepared from the photocurable composition. Additional layers on the plate include slip and release films to protect the photosensitive surface. Prior to processing the plate, the additional layers are removed, and the photosensitive layer is exposed to radiation in an imagewise fashion. The unexposed areas of the layer are then removed in developer baths.

Removal of unexposed layers comprising photocurable compositions such as those disclosed in U. S. Patent No. 2,760,863 require the use of developer baths comprising environmentally unsafe, organic solvents such as tetrachloroethylene, perchloroethylene, 2-butanone, benzene, toluene, xylene, trichloroethane and solvent mixtures such as tetrachloroethylene/n-butanol. However, due to the toxicity, high volatility and low flash point, their use gives rise to hazardous conditions and creates pollution problems. Thus, recently there has been a strong interest in the field to develop photosensitive layers in non-organic solvent developing solutions, e.g. aqueous or alkaline-aqueous solutions. However, the compositions resulting from recent attempts to achieve aqueous developable plates demonstrate deficiencies in mechanical properties or are unsuitable for use with a wide variety of printing inks, especially alcohol based inks.

For instance, in addition to possessing an aqueous developable photosensitive layer, a flexographic printing plate must have sufficient flexibility to wrap around a printing cylinder, yet be strong enough to withstand the rigors experienced during typical printing processes. Further, the printing plate should possess a low hardness to facilitate ink transfer during printing.

Previous aqueous developable compositions have not possessed all the desirable features such as flexibility, softness and solvent resistance to inks typically used in printing. For example, U. S. Patent No. 4,023,973 describes a photosensitive composition comprising of a maleic anhydride adduct of a 1,2-polybutadiene. However, because the 1,2 content of this material is very high, i.e. 70% or more, this composition has an undesirably high rubber hardness.

Furthermore, other water-developable photosensitive compositions which contain as the main component a high molecular weight polymer such as polyvinyl alcohol, cellulose, polyethylene oxide, or the like, are insufficient in flexibility and rubber hardness and hence are unsuitable for use in flexographic printing plates.

Finally, it is also important that the photosensitive layer of the printing plate be dimensionally stable during storage. For example, some compositions used for making plates have shown inferior stability properties when used in solid flexographic printing plates in that the compositions become tacky and pasty during storage. Those inferior properties have been attributed to the low molecular weight of the polymers used to prepare the printing plates. See U. S. Patent No. 4,762,892 to Koch et al. and discussion of low molecular weight polymers disclosed in Japanese Kokoku 57-23693.

One attempt to develop an aqueous developable, flexible printing plate is illustrated in U. S. Patent 4,916,045 (Koch et al., assigned to BASF Aktiengesellschaft). Koch et al.'s '045 patent describes a photosensitive recording element consisting primarily of an ionic polymer. The ionic polymer is prepared by the partial esterification or amidation of succinic acid anhydride side groups on an alkadiene polymer. The resultant polymer is then converted into an ionic polymer by reaction with suitable compounds. With reference to the preferred materials, the reference is directed to oligomers having a polybutadiene backbone, side radicals prepared by (a) maleating the polybutadiene, (b) esterifying the resultant pendant succinic anhydride ring with hydroxyethyl methacrylate (HEMA), and (c) neutralizing the carboxyl groups generated during the esterification with a cation from Groups I to V of the Periodic Table. The preferred cation is zinc.

Two processes are described for the preparation of the partially esterified or amidated polymer. The first process involves the reaction of the succinic acid anhydride side groups with hydroxy or amino derivatives of compounds having an olefinically unsaturated double bond (such as hydroxyethyl methacrylate) to introduce a side radical ("B" in the reference), and, if desired, with compounds containing polar groups to produce a further side radical ("D" in the reference). These two compounds are reacted in one step, not sequentially. The second process for partial esterification involves the hydrolysis of all of the succinic acid anhydride side groups with water and reaction of the acid groups so formed with acid reactive compounds containing unsaturated double bonds to introduce side radical "B" or acid reactive compounds containing polar groups to introduce side radical "D".

However, when prepared from certain monovalent cations, Koch et al.'s ionic polymer does not appear to result in a flexible printing plate having sufficient mechanical properties. For instance, it has been found that when an ionomer prepared according to Koch et al.'s teaching is prepared with sodium, the dimensional stability and flexibility of a printing plate prepared from that ionomer are insufficient for use as a plate in flexographic printing. See Example 8 herein. On the other hand, it has recently been found that monovalent cation, e.g. sodium, based ionomers prepared from other polymers will result in flexographic printing plates having excellent dimensional stability and flexibility. Such plates also demonstrate minimal ink swell in aqueous and solvent based inks. See Example 9.

### Summary of the Invention

Accordingly, it is an object of the invention to prepare a photocurable composition which is suitable as an aqueous developable, photosensitive layer on a flexible photosensitive article such as a flexible printing plate.

It is an object of the invention to prepare a solid, photosensitive layer which is flexible, yet strong and durable.

It is also an object to prepare a solid photosensitive layer which when cured in an imagewise pattern results in a relief pattern layer which easily transfers ink in instances the layer is that of a flexible printing plate.

It is thus a further object of the invention to provide a novel photocurable composition possessing the aforementioned properties, the photocurable composition comprising an ionic prepolymer derived from a chain extended maleic anhydride adduct of a base polymer (a polybutadiene or a butadiene copolymer) wherein a significant degree of the segments of the base polymer has a 1,4 microstructure.

A preferred base polymer maleic anhydride adduct is made from polybutadiene having a molecular weight of about 8000 and having about 8 anhydride groups per molecule. In preparing the maleic anhydride-base polymer, the maleic anhydride groups are converted to succinic anhydride groups. The two terms may be used interchangeably.

The present invention provides, a prepolymer comprising segments of the structure: 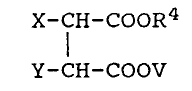 where X and Y are different from one another and are H or a carbon atom of the base polymer; the base polymer being polybutadiene or a butadiene copolymer;
V is H or M;
R⁴ is R or 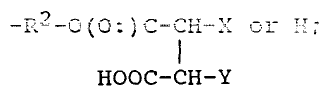
R is -(CH₂)ₙ-OC(:O)C(R¹)=CH₂;
R¹ is H or methyl;
R² is 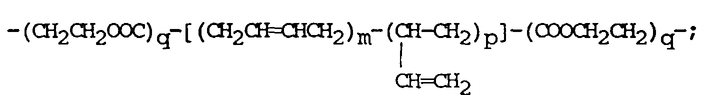
M is Li, Na, or K;
n is 2, 3, or 4;
m + p = 15-130; and m is 70-100% of m + p;
q is 0 or 1;
provided that in at least one segment R⁴ is R;
in at least one segment R⁴ is 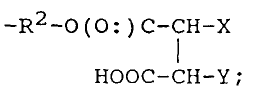 in at least one segment R⁴ is H; and
in at least one segment V is M.

Preferably the prepolymer has an average molecular weight of at least 15,000 and wherein the base polymer is a polybutadiene.

The invention also provides a photocurable composition comprising a prepolymer of the invention and an unsaturated monomer and a flexible photosensitive article comprising a support and a solid photosensitive layer comprising such a photosensitive composition.

In a further aspect the invention provides a process for the preparation of an aqueous dispersible photocurable prepolymer for a photosensitive article which process comprises:
(a) reacting anhydride groups of a maleic anhydride adduct of a polybutadiene or butadiene copolymer with a reagent having olefinically unsaturated groups and an anhydride reactive group; where, upon reaction the anhydride groups are opened and carboxylic acid groups are formed;
(b) chain-extending the adduct by reacting a polymeric alkadiene polyol of the structure [R²]-OH_{w} where w=2-3 and R² is as hereinbefore defined with unreacted anhydride groups from (a) to increase the molecular weight (Mₙ) of the thus chain-extended polymer to at least 2500;
(c) then reacting the remaining unreacted anhydride groups from (a) and (b) with water to form more carboxylic acid groups; and
(d) then neutralizing a portion or all of the carboxylic acid groups in (c) with Li-, Na-, or K-containing base.

The thus produced product may be applied in a further step (e) to a support to form a flexible photosensitive article. The process can also comprise adding photocurable unsaturated monomers and photoinitiators, e.g., to the product of (d) above.

The invention yet further provides a method of forming a flexographic printing plate which method comprises:
(1) coating a urethane-coated support with a non-ionomer polymer comprising segments of the structure 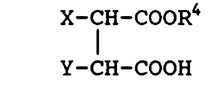 and
(2) applying onto the coating in (1) a layer of an ionomer comprising segments of the structure: 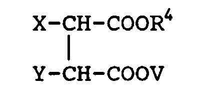 wherein the various symbols are as hereinbefore defined.

The invention also provides a printing plate obtainable by such a method wherein said urethane-coated support and said ionomer layer further comprise unsaturated monomer. Optionally said urethane-coated support and said ionomer layer further comprise photoinitiator.

The product of process step (c) (sometimes herein referred to as "non-ionomer") comprises segments of the structure: 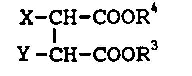 where X and Y are different from one another and are H or a carbon atom of the base polymer;
R is -(CH₂)ₙ-OC(:O)C(R¹)=CH₂;
R¹ is H or methyl;
R² is 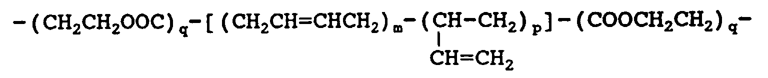
R³ is H;
R⁴ is R or 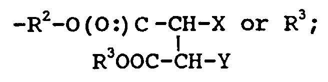
n is 2, 3, or 4;
m + p = 15-130; and m is 70-100% of m + p;
q is 0 or 1;

Provided that in at least one segment R⁴ is R; in at least one segment R⁴ is 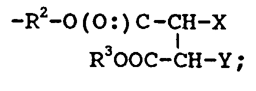 and in at least one segment R⁴ is R³. For practical and statistical reasons, however, more than one segment will likely have such R⁴ groups.

The product of process step (d) (herein, "ionomer") comprises segments substantially the same as those in the product of (c), except that R³ is replaced by R⁵. R⁵ is R³ or M, where M is Li, Na, or K, provided that in at least one segment R⁵ is M. For practical and statistical reasons, however, more than one segment will likely have R⁵ groups wherein R⁵ is M. Thus, generically speaking, the aforesaid segments may be described as 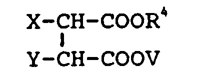 where V is R³ or R⁵, depending respectively on whether the product is from (c) or (d).

In R² the segments numbered m and p, although shown for the sake of simplicity in block polymer form, can actually be in random form, or random plus block form.

In a preferred embodiment (cf Example 1) n is 2, R¹ is methyl, m is about 70, p is about 23, q is 1, and molecular weight of the base polymer is about 8000.

The results of (a), (b), or (c), and (d) above may include segments that are not chain-extended, so that the final photopolymer of (c) and/or (d) may comprise R²-free segments.

Herein molecular weights are number average, Mₙ determined by GPC using polystyrene standards.

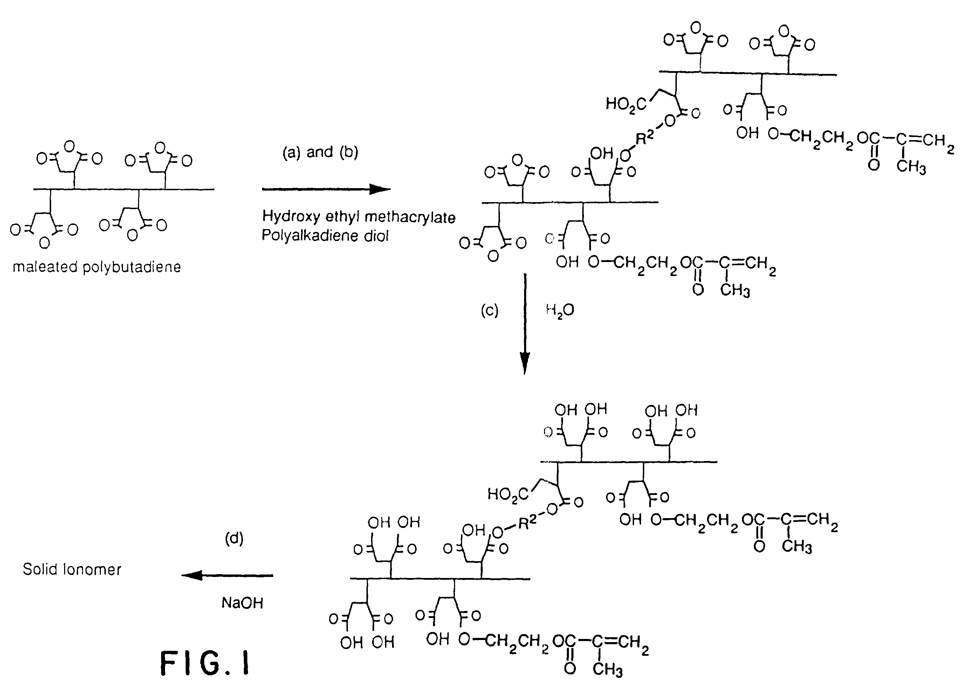

Referring now to Figure 1, the principal unit processes in the preferred embodiment of the invention are given in short summary, starting with maleated polybutadiene and concluding with solid ionomer. The species used includes hydroxyethyl methacrylate (HEMA). R₂ indicates the central portion of polybutadiene diol. In Steps (a) and (b) maleated polybutadiene is reacted with HEMA and chain-extending polybutadiene diol. The HEMA opens the anhydride group, esterifying one of the carbonyls arid converting the other to carboxylic acid, -COOH. During the same reaction, a molecule of the chain-extending diol opens anhydride groups on two or three molecules of maleated polybutadiene and forms -C(:O)0-R₂-OC(:0)- linkages, where the carboxyls derive from residual maleic (succinic) anhydride moieties. Two or more chain-extending diols may link any two given maleated base polymer molecules; on the other hand it is expected that some maleated base polymers will escape the chain-extending reaction.

Continuing with Figure 1, the product of (a) and (b) is reacted with water in (c). This results in hydrolysis of the remaining succinic anhydride groups. The product now comprises copious -COOH groups and little or no anhydride groups. This (c) product is referred to herein as a "non-ionomer" or "preionomer". In (d) the non-ionomer of (c) is treated with NaOH to neutralize some of or all of the -COOH groups and produce the final ionomer product. The product of (d) is ready for formulation with UV-sensitive additives and photoinitiators and solvent casting on a support as explained in detail hereinafter. In Figure 1, for the sake of simplicity, reaction of the anhydride group with HEMA and/or with the extender is shown with the carbonyl group nearest the base polymer backbone. Actually, the reaction may occur with either anhydride carbonyl, thus (with HEMA): 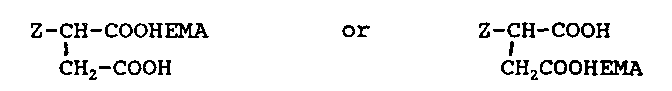 wherein Z is the backbone of the base polymer adduct.

### Brief Description of the Drawing

Figure 1 is a simplified flow sheet which illustrates preparing the invention.

### Detailed Description of the Invention

The photocurable or photosensitive composition (the term "photocurable" and "photosensitive" being used interchangeably throughout) can be a prepolymer derived from a maleic anhydride adduct of polybutadiene having at least 70 to 80% 1,4 microstructure. As discussed later, the photocurable composition preferably comprises additional photocurable compounds such as unsaturated monomers. "Maleic anhydride" includes substituents as hereinafter discussed.

The term 1,4 microstructure refers to the butadiene segment's structure which results from 1,4 addition to a 1,3 butadiene monomer during polymerization. The general structure for a 1,4 polybutadiene is illustrated below:

-[CH₂ - CH = CH - CH₂]ₘ-

wherein m is a positive integer depending on the amount of polymerization desired and the molecular weight of the polymer. The remaining percentage of butadiene segments have a 1,2 microstructure which results from 1,2 addition during polymerization. In instances where butadiene segments having 1,2 microstructure are present, the polybutadiene has pendent vinyl groups on its structure, as illustrated below: 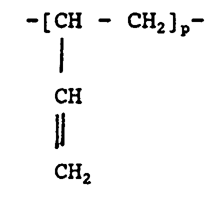 wherein p is a positive integer depending on the amount of polymerization and the molecular weight of the polymer. The formation of the 1,4 microstructure is dependent upon reaction conditions used during the polymerization reaction and can be regulated by known techniques.

For instance, the choice of catalyst or promoter, variation in the polarity of solvents used, variations in the reaction temperatures and the presence of transition metals all influence the 1,4 content of the resulting polymers' microstructure. In general, a polymer having increased 1,4 content will lead to higher elasticity and an increase in the rubbery nature of the composition. It is believed that those properties can be attributed to less crosslinking between pendent vinyl groups which are present on the polybutadienes which have a higher degree of 1,2 microstructure.

The adduct can have a maleic anhydride content of from 5-30 percent by weight of the adduct and preferably contains 8-20% by weight. Lower amounts of anhydride content decreases the aqueous developability of the photocurable composition, and layers made therefrom, while higher amounts causes the composition and layers therefrom to be hard and less flexible.

The addition of the maleic anhydride to the polybutadiene can be accomplished by reacting the polybutadiene with a maleic anhydride of the general formula 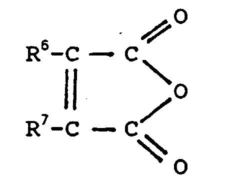 wherein R⁶ and R⁷ are individually a member of the group consisting of hydrogen, halogen, carboxyl, linear or cyclic alkyl containing 1-20 carbon atoms, aryl, alkaryl and aralkyl containing 6 to 20 carbon atoms.

For example, the adduct can be formed by heating the polybutadiene and the maleic anhydride to about 220°C, with stirring in a halogenated aromatic hydrocarbon solvent, such as α-chloronapthalene. The reaction can be carried out in the presence of an inhibitor so as to prevent side reactions. Suitable inhibitors include copper, copper salts and copper chelate complexes. The maleic anhydride can be added in any proportion from a minimum of 5% by weight up to 30% by weight, with the percentage of bonded maleic anhydride preferably being between 8 and 20% by weight. The molecular weight of the adduct can be between 1000 and 20,000 number average and is preferably 2,000 to 12,000. Other known techniques of adding maleic anhydride can be used. See U. S. Patent 3,974,129 and W. Cloak, Industrial Engineering Chemistry, Vol. 4, p.2095 (1955). Commercially available maleic anhydride adducts of 1,4 polybutadiene include a material designated as LX16-10MA from Revertex Ltd. and a material designated as Ricon 131 MA from Colorado Chemical Specialties.

The adduct may also comprise a base polymer which is a butadiene copolymer with styrene, acrylonitrile, chloroprene, isobutylene, propylene, ethylene, or acrylic and methacrylic acids and esters. In instances where a copolymer is used, at least 70 to 80% of the butadiene segments should have 1,4 microstructure. Commercially available maleic anhydride adducts of a butadiene copolymer with styrene include Ricon 184 MA from Colorado Chemical Specialties.

The adduct is chain-extended and esterified. These two reactions will be described separately.

### (a) Esterification

A portion of the adduct's anhydride groups is esterfied with a reagent having an olefinically unsaturated group and a functional group which-reacts with and opens the anhydride groups to form carboxylic acid and ester groups. Preferably, the reagent has a structure of 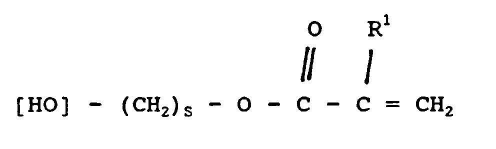 wherein R¹ is hydrogen or methyl and S = 2 to 4 and [HO] represents the anhydride reactive group. An example of a reagent having hydroxy as the anhydride reactive group is hydroxyethyl methacrylate (HEMA).

The esterification reaction (and chain extension reaction) is carried out at temperatures from 50°C to 120°C, preferably at about 95-100°C for 1 to 6 hours. The reaction is preferably carried out in an organic solvent in which the adduct, vinyl compound, and extension agent are soluble. An organic solvent is needed to facilitate formation of the high molecular weight and high viscosity of the chain extended product. The esterification reagent is added in amounts to react with 5 to 40% of the adduct's anhydride groups. The esterification reaction creates pendent groups having the following structure P: 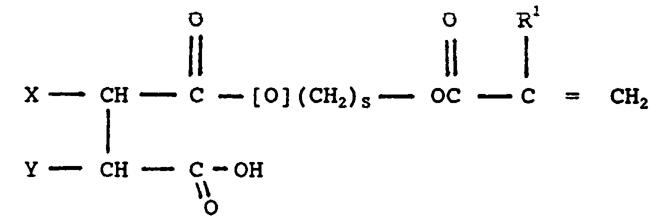 wherein [0] is the oxygen linkage formed by the anhydride reactive group and X, Y, R¹, and S are as above defined.

As illustrated above, the pendent groups P provide photocurability to the polybutadiene adduct. When the adduct is exposed to UV radiation, the vinyl groups in P crosslink, thus curing the composition and imparting tensile strength and modulus to any layer prepared from the composition, as well as imparting improved swell resistance of the polymer in solvents. Further, the esterification reaction opens the anhydride groups to form free carboxylic acid groups, thus providing a water dispersible composition which can be developed in aqueous or aqueous-alkaline solutions.

### (b) Chain Extension

The adduct is chain extended to improve the physical properties, i.e., increase elongation and provide a stable and durable photosensitive surface. The chain extending agent is a polymeric alkadienyl diol or triol of the structure [R²]-[-OH]₂ or [-OH]₃, where R² is as previously defined, and the [-OH] groups are directly attached to the polymeric alkadienyl backbone in the case of q = 0 or attached to the (COOCH₂CH₂-) groups in the case of q = 1. The chain-extending agent has a molecular weight of about 1000-7000.

In the chain extension reaction carboxyl groups on two base polymer adducts are joined, thus: 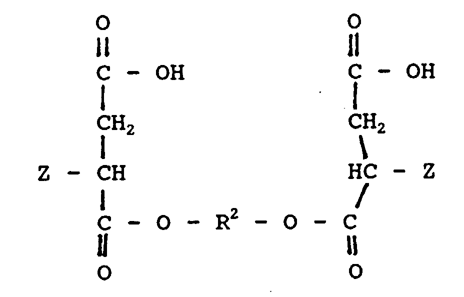 wherein Z is the backbone of the base polymer adduct.

As shown, chain extension of the adducts occurs through a portion of the anhydride groups.
Preferably, chain extension occurs through 5 to 30 % of the adduct's original anhydride groups.

### (c) Hydrolysis

To open the remaining anhydride groups the chain-extended product is reacted with water. This reaction produces additional carboxylic acid groups which when neutralized with monovalent cations as herein described, form a solid photopolymer and increases the water dispersibility of the photocurable composition.

### (d) Neutralization

Finally, to provide the ionomer previously illustrated the carboxyl groups are neutralized by bases that provide Li, Na, or K ions, such as (but not limited to) lithium hydroxide, sodium hydroxide, or potassium hydroxide. The neutralized carboxylic acid groups on the ionomer are represented by -COOV wherein V is R₅ and R₅ is M, i.e. Li, Na or K. It has been found that the resulting salts have improved physical properties such as higher resilience, higher elongation and better resistance to swell in organic solvents commonly used in printing inks.

The selection of one of the three stated cations permits synthesis of a photopolymer tailor-made for a specific end use. For example, Li gives lower swells in aqueous based printing inks, while Na gives lower swells in solvent based inks.

### Proportions

The relative proportions of ingredients in forming the photopolymer are important. For example, too much HEMA results in a product too hard to permit good ink transfer. Too little chain extension results in a product with low elongation, and too little hydrolysis of the remaining anhydride groups will yield a material which will not become a solid when neutralized with monovalent cations.

Based on 100 parts by weight of maleic anhydride adduct of base polymer (polyalkadiene homo- or copolymer), of which 5-30, preferably 8-20 parts by weight is maleic anhydride moiety, we use (in parts by weight except as noted):
Olefinically unsaturated side chain additive (e.g., HEMA), 0.7-3.2, preferably 2.0-2.6;
Polyalkadienyl polyol chain extender (e.g., polybutadiene diol), 10-63, preferably 30-50;
Water, sufficient to complete hydrolysis of substantially all remaining anhydride groups still present after steps (a) and (b), and suitably in slight excess;
Li-, Na-, or K-containing base, sufficient to neutralize 40-100 % of the carboxylic acid groups, preferably 50-70 % in the non-ionomer with formation of ionomer.

### Physical Properties

To succeed commercially a flexographic printing plate should meet certain physical requirements, typically:
(1) Elongation (ASTM D 412) should exceed about 140%
(2) Tensile strength (ASTM D 412) should exceed about 2070 kPa (300 psi)
(3) Tensile modulus (1% elongation) (ASTM D 412) should not exceed about (13,800 kPa (2000 psi)
(4) Shore hardness (ASTM 2240) should not exceed about 60.

Printing plates prepared from prepolymers in accordance with the processes of the instant invention readily meet these criteria.

As mentioned earlier, the photocurable compositions can also contain components in addition to the above described neutralized prepolymer. For instance, photocurable monomer diluents are preferably added. Operable diluents include reactive acrylic or methacrylic diluents of the formula 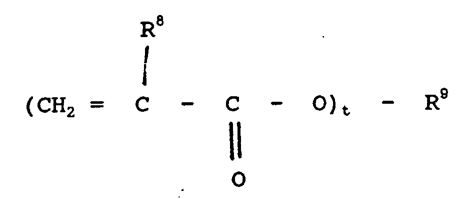 wherein R⁸ is hydrogen or methyl, and R⁹ is an organic moiety having the valence of t, and t is 1 or more. Such reactive acrylic diluents include, but are not limited to, trimethylolpropane triacrylate, hexanediol diacrylate, 1,3-butylene glycol diacrylate, diethylene glycol diacrylate, 1,6-hexanediol diacrylate, neopentyl glycol diacrylate, polyethylene glycol-200 diacrylate, tetraethylene glycol diacrylate, triethylene glycol diacrylate, pentaerythritol tetraacrylate, tripropylene glycol diacrylate, ethoxylated bisphenol-A diacrylate, trimethylolpropane triacrylate, di-methylolpropane tetraacrylate, triacrylate of tris(hydroxyethyl) isocyanurate, dipentaerythritol hydroxypentaacrylate, pentaerythritol triacrylate, ethoxylated trimethylolpropane triacrylate, triethylene glycol dimethacrylate, ethylene glycol dimethacrylate, tetraethylene glycol dimethacrylate, polyethylene glycol-200 dimethacrylate, 1,6-hexanediol dimethacrylate, neopentyl glycol dimethacrylate, polyethylene glycol-600 dimethacrylate, 1,3-butylene glycol dimethacrylate, ethoxylated bisphenol-A dimethacrylate, trimethylolpropane trimethacrylate, diethylene glycol dimethacrylate, 1,4-butanediol diacrylate, diethylene glycol dimethacrylate, pentaerythritol tetramethacrylate, glycerin dimethacrylate, trimethylolpropane dimethacrylate, pentaerythritol trimethacrylate, pentaerythritol dimethacrylate, pentaerythritol diacrylate, polybutadiene diacrylate and the like which can be added to the composition. Monoacrylates such as cyclohexyl acrylate, isobornyl acrylate, lauryl acrylate, dicyclopentenyloxyethyl acrylate and tetrahydrofurfuryl acrylate and the corresponding methacrylates are also operable as reactive diluents.

Other suitable diluents include polymerizable ethylenically unsaturated addition monomers described in U.S. Patent 4,442,302. Those monomers include monofunctional, difunctional or polyfunctional compounds based on moieties such as (meth)acrylonitriles and acrylamides, as well as the (meth)acrylics described above.

Suitable photoinitiators for the photocurable composition include benzoin alkyl ethers, such as benzoin methyl ether, benzoin ethyl ether, benzoin isopropyl ether and benzoin isobutyl ether. Another class of photoinitiators are the dialkoxyacetophenones exemplified by 2,2-dimethoxy-2-phenylacetophenone, i.e., Irgacure® 651 (Ciba-Geigy); and 2,2-diethoxy-2-phenylacetophenone. Still another class of photoinitiators are the aldehyde and ketone carbonyl compounds having at least one aromatic nucleus attached directly to the carboxyl group. These photoinitiators include benzophenone, acetophenone, o-methoxybenzophenone, acenaphthene-quinone, valerophenone, hexanophenone, alpha-phenyl-butyrophenone, p-morpholinopropiophenone, dibenzosuberone, 4-morpholinobenzophenone,4'-morpholinodeoxybenzoin, p-diacetylbenzene, 4-aminobenzophenone, 4'-methoxyacetophenone, benzaldehyde, alpha-tetralone, 9-acetylphenanthrene, 2-acetylphenanthrene, 10-thioxanthenone, 3-acetylphenanthrene, 3-acetylindone, 9-fluorenone, 1-indanone, 1,3,5-triacetylbenzene, thioxanthen-9-one, xanthene-9-one, 7-H-benz[de]-anthracene-7-one, 1-naphthaldehyde, 4,4'-bis(dimethylamino)-benzophenone, fluorene-9-one, 1'-acetonaphthone, 2'-acetonaphthone, 2,3-butanedione, acetonaphthene, benz[a]anthracene 7,12 dione, etc. Phosphines such as triphenylphosphine and tri-o-tolylphosphine are also operable herein as photoinitiators. The photoinitiators or mixtures thereof are usually added in an amount ranging from 0.01 to 5% by weight of the total weight of the photocurable composition.

Other additives to the photocurable composition can be included. To inhibit premature crosslinking during storage of the prepolymer containing compositions of this invention, thermal polymerization inhibitors and stabilizers are added. Such stabilizers are well known in the art, and include hydroquinone monobenzyl ether, methyl hydroquinone, amyl quinone, amyloxyhydroquinone, n-butylphenol, phenol, hydroquinone monopropyl ether, phenothiazine and nitrobenzene, and mixtures thereof. Such additives are used in an amount within the range of from 0.01 to 2% by weight of the prepolymer. These stabilizers are effective in preventing crosslinking of the prepolymer composition during preparation, processing and storage.

The compositions also may contain up to 50% by weight of an inert particulate filler which is essentially transparent to actinic light. Such fillers include the organophilic silicas, bentonites, silica and powdered glass. Such fillers can impart desirable properties to the photocurable compositions and reliefs on printing plates containing those compositions.

The photocurable composition can then be shaped and formed as a solid layer of suitable thickness according to conventional solvent casting, i.e., dissolving the composition in a solvent, shaping the solution into a film or plate and removing the solvent. Conventional extrusion calendaring or hot press techniques can also be used. Solid layers of the photosensitive composition in the form of a film can be adhered to supports such as those comprising polyester, nylon or polycarbonate. Other suitable supports include woven fabrics and mats, e.g. glass fiber fabrics, or laminated materials made of, for example, glass fibers and plastics. It is preferred that the supports are dimensionally stable and resistant to the washout solutions.

It is necessary to protect photosensitive surfaces from contamination by dirt and dust during storage before being exposed and washed. Such protection is accomplished by lamination or application of a flexible protective cover sheet to the side of the photocurable composition opposite that of the support. As mentioned before the photocurable compositions can sometimes be tacky and it is desirable to apply a release film to the surface of the photosensitive layer before application of the coversheet. This release film may consist of a thin, flexible and aqueous dispersible polymeric film. This film allows for intimate contact between the surface of the photocurable composition opposite to the support and an image bearing negative applied to the surface.

Photosensitive articles comprising a support having a solid layer or surface comprising the photocurable composition, e.g. solid flexographic printing plates, can then be processed by well known techniques for imagewise exposure to actinic light. Preferably, the light should have a wavelength of from about 230-450 nm. Exposure is through a negative placed between the light source and the photosensitive surface. Suitable sources of light include Type RS sunlamps, carbon arc lamps, xenon arc lamps, mercury vapor lamps, tungsten halide lamps and the like.

Exposure periods depend upon the intensity of the actinic light, thickness of the plate and the depth of the relief desired on the printing plate. Periods of from 2 to 20 minutes are preferred.

After exposure and the negative has been removed, the unexposed areas of the photosensitive surface can be developed in aqueous solutions. Suitable solutions include those of nonionic and cationic surfactants, as well as basic and semi-aqueous basic solutions and combinations thereof. Such surfactants are commercially available as Triton® X-100 from Union Carbide Company and Igepal® C0-730 from GAF Corporation.

The following are examples illustrating the instant invention.

### Example 1

### Preparation of Non-Ionomer Prepolymer

409g of a maleated polybutadiene (Mₙ = 8800, degree of maleation = 9%), 165g of hydroxy terminated polybutadiene (hydroxyl number = 22.65), 9.1g of hydroxyethyl methacrylate, 2.3g of butylated hydroxy toluene antioxidant (BHT) and 726g of toluene were charged into a 3L resin kettle equipped with an overhead stirrer, condenser and thermocouple. This mixture was heated at 95-100°C with stirring for 4 hours at which time the reaction was complete as determined by IR spectroscopy. The solution was cooled to 60°C, and an excess of water added (8g) and then stirred for an additional 16 hours. Analysis by IR spectroscopy showed the complete disappearance of the anhydride adsorption band at 1780 cm⁻¹ indicating the reaction was over.

### Example 2

### Preparation of 60% Sodium Ionomer

To 41g of the prepolymer prepared in Example 1 (92g of solution) was added 1g NaOH dissolved in 12g methanol. This mixture was stirred at room temperature for 1 hour. 4.11g of hexanediol dimethacrylate, 2.75g of dicyclopentenyloxyethyl methacrylate and 0.484g Irgacure 651 were then added and mixed for an additional hour.

### Example 3

### Preparation of 60% Lithium Ionomer

To 41g of a prepolymer prepared as in Example 1 was added 0.95g lithium methoxide dissolved in 18g methanol. After stirring for one hour, 4.11g hexanediol dimethacrylate, 2.75g dicyclopentenyloxyethyl methacrylate and 0.484g Irgacure 651 was added and mixed until well blended.

### Example 4

### Preparation of 60% Potassium Ionomer

To 41g of a prepolymer prepared as in Example 1 was added 1.62g of 85% potassium hydroxide in 12g methanol. After stirring for one hour, 4.11g hexanediol dimethacrylate, 2.75g dicyclopentenyloxyethyl methacrylate and 0.484g Irgacure 651 was added and the solution mixed for an additional hour.

### Examples 5 to 7

### (Effect of cation on physical properties and swell in aqueous and solvent inks.)

The formulated products of Examples 2 to 4 were solvent cast to produce solid, dry films. The films were cured by exposure to UV light and their mechanical properties and swell resistance in typical flexographic inks determined.

| | Tensile | | | | | 24 Hour Weight Gain | |
|---|---|---|---|---|---|---|---|
| | Modulus kPa (psi) | Elong. % | Strength kPa (psi) | Resilience % | Shore A | Solvent Ink | Aqueous Ink |
| Example 5 (Na) | 3810(553) | 180 | 2495(362) | 48 | 60 | 6.0% | 7.4% |
| Example 6 (Li) | 3950(573) | 197 | 2585(375) | 46 | 57 | 9.4% | 5.9% |
| Example 7 (K) | 2710(393) | 140 | 2240(325) | 51 | 60 | 8.3% | 17.0% |

The following Example shows the effect of high HEMA content on physical properties as well as the effect of no hydrolysis on the solidness of monovalent cation salts.

### Example 8 (Reference)

### Preparation of 60% Sodium Ionomer

182g of a maleated polybutadiene (Mₙ = 8800, degree of maleation = 9%), 20g hydroxyethyl methacrylate, 1.0g BHT and 160g toluene were charged into a 21 resin kettle equipped with an overhead mechanical stirrer, condenser and thermocouple. The mixture was heated at 90°C with stirring until IR analysis indicated the reaction was complete (disappearance of the anhydride adsorption band at 1780 cm⁻¹).

To 24.4g of prepolymer (50g of solution) was added 0.46g NaOH dissolved in 6g methanol. After stirring for 1 hour, 2.4g hexane diol dimethacrylate, 1.6g dicyclopentenyloxyethyl methacrylate and 0.3g Irgacure 651 was added to the ionomer solution and mixed thoroughly. This mixture was solvent cast to produce a 510µm (20 mil) film. The tacky, non-solid film obtained was unsuitable for use as a solid printing plate due to dimensional instability. The mechanical properties of a film cured by exposure to UV light are shown below.

| Tensile Modulus | Elongation | Tensile Strength | Shore A Hardness |
|---|---|---|---|
| 26550 kPa | | 5860 kPa | |
| (3850 psi) | 50% | (850 psi) | 80 |

### Example 9

### A Preferred Embodiment

A formulated sodium ionomer solution prepared as described in Example 2 was solvent cast onto a polyester support to provide a solid, nontacky 1700µm (67 mil) thick film. This film was imaged by UV exposure through a negative and developed in a 4% Triton RW-150 surfactant solution at 60°C (140°F). A printing plate with 30 mils relief and excellent reproduction of the negative film image was obtained. This plate was found to have excellent ink transfer with both aqueous and solvent-based inks.

A conventional photopolymer backing is a polyester film (e.g., "Mylar") coated with a urethane adhesive. The ionomer forms of the photopolymers of this invention do not adhere well to this particular type of backing. We have found, however, that we can coat such backing with a thin coating of our photopolymer in its non-ionomer form in solvent (result of step (c)), and that, so primed, the photopolymer in ionomer form (result of step (d)) (and preferably promptly applied) will then adhere firmly to the plate. Both coatings can be applied by conventional solvent casting onto a belt, with application of several layers. Evaporation of solvent is completed by conventional oven drying.

## Claims

1. A prepolymer comprising segments of the structure: 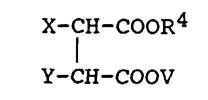 where X and Y are different from one another and are H or a carbon atom of the base polymer; the base polymer being polybutadiene or a butadiene copolymer;
V is H or M;
R⁴ is R or 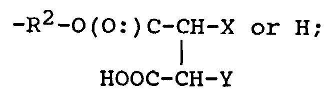
R is -(CH₂)ₙ-OC(:O)C(R¹)=CH₂;
R¹ is H or methyl;
R² is 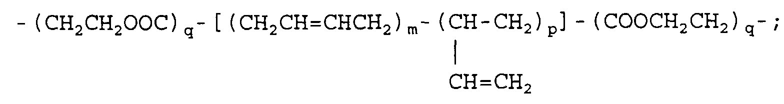
M is Li, Na, or K;
n is 2, 3, or 4;
m + p = 15-130; and m is 70-100% of m + p;
q is 0 or 1;
provided that in at least one segment R⁴ is R;
in at least one segment R⁴ is 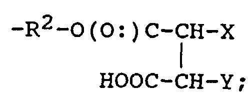 in at least one segment R⁴ is H; and
in at least one segment V is M.

2. Prepolymer according to claim 1 wherein V is H.

3. Prepolymer according to claim 1 wherein V is H or M, provided that in at least some segments, V is M.

4. A prepolymer according to any one of claims 1 to 3 wherein the segments are derived from a polybutadiene maleic anhydride adduct wherein said adduct is a polybutadiene having a molecular weight of about 8000 and having about 8 anhydride groups per molecule.

5. A prepolymer according to claim 4 wherein said adduct has been prepared with a maleic anhydride of the formula 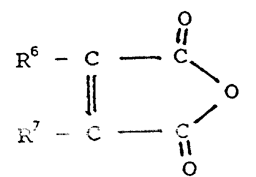 wherein R⁶ and R⁷, which may be the same or different, each represents hydrogen, halogen, carboxyl, linear or cyclic alkyl containing 1-20 carbon atoms, or aryl, alkaryl or aralkyl containing 6 to 20 carbon atoms.

6. A prepolymer according to any one of the preceding claims wherein the base polymer is a polybutadiene comprising at least 70% 1,4 microstructure.

7. A prepolymer according to any one of the preceding claims with an average molecular weight of at least 15,000 and wherein the base polymer is a polybutadiene.

8. A prepolymer according to claim 1 wherein n=2 and R¹ is methyl.

9. A prepolymer according to claim 3 wherein n is 2; R¹ is methyl; m is about 70, p is about 23, q is 1, and the molecular weight of the base polymer is about 8000.

10. A photocurable composition comprising a prepolymer according to any one of claims 1 to 9 and further comprising an unsaturated monomer.

11. A photocurable composition according to claim 10 wherein said unsaturated monomer is a methacrylate or acrylate.

12. A photocurable composition according to claim 10 or 11 further comprising a photoinitiator.

13. A flexible, photosensitive article comprising a support and a solid photosensitive layer comprising a photocurable composition as defined in any one of claims 10 to 12.

14. A process for the preparation of an aqueous dispersible photocurable prepolymer for a flexible photosensitive article which process comprises
(a) reacting anhydride groups of a maleic anhydride adduct of a polybutadiene or butadiene copolymer with a reagent having olefinically unsaturated groups and an anhydride reactive functional group, where upon reaction, the anhydride groups are opened and carboxylic acid groups are formed;
(b) chain extending the adduct in (a) by reacting a polymeric alkadiene polyol of the structure [R²]-[OH]_{w} wherein w = 2-3 and R² is as defined in claim 1 with unreacted anhydride groups of the reaction product of (a), such that the molecular weight (Mn) of the chain extended polymer is at least 2500; and
(c) reacting the anhydride groups remaining after steps (a) and (b) with water to form carboxylic acid groups; and, optionally,
(d) neutralizing at least a portion of the carboxylic acid groups in (c) with a Li-, Na-, or K-containing base.

15. Process according to claim 14, wherein, based on 100 parts by weight of maleic anhydride adduct of polybutadiene or butadiene copolymer, in parts by weight, the process comprises:
(1) 5-30 parts of the anhydride groups of the adduct;
(2) 0.7-3.2 parts of the reagent in step (a); and
(3) 10-63 parts of the polymeric alkadiene polyol.

16. Process according to claim 14 or 15 which comprises:
(1) 8-20 parts of the anhydride groups;
(2) 2.0-2.6 parts of the reagent in step (a); and
(3) 30-50 parts of the polymeric alkadiene polyol.

17. Process according to claim 14, 15 or 16 wherein 40-100 mol % of the carboxylic acid groups in (c) are neutralized.

18. Process according to claim 17 wherein 50-70 mol % of the carboxylic acid groups in (c) are neutralized.

19. Process according to any one of claims 14 to 18 wherein the reaction product in (c) is cast onto a support or the neutralized product of step (d) is cast or extruded onto a support.

20. Process according to any one of claims 14 to 19 wherein said adduct is prepared from a polybutadiene having a molecular weight of about 8000 and about 70% 1,4 microstructure and said adduct has about 8 anhydride groups per molecule.

21. Process according to any one of claims 14 to 20 wherein in (b) the polymeric alkadiene polyol is a diol wherein m is about 70% of m t p, and p is about 23.

22. Process according to any one of claims 14 to 21 wherein the reagent in step (a) is HO-(CH₂)ₙ-O-C(:O)-C(R¹)=CH₂ wherein R¹ is hydrogen or methyl, and n = 2 to 4.

23. Process according to any one of claims 14 to 22 further comprising mixing the neutralized reaction product with unsaturated monomers and photoinitiators.

24. Method of forming a flexographic printing plate which method comprises:
(1) coating a urethane-coated support with a non-ionomer polymer comprising segments of the structure 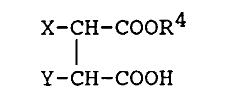 and
(2) applying onto the coating in (1) a layer of an ionomer comprising segments of the structure: 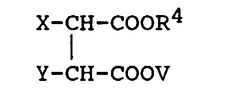 wherein the various symbols are as defined in claim 1.

25. Printing plate obtainable by the method of claim 24 wherein said urethane-coated support and said ionomer layer further comprise unsaturated monomer.

26. Printing plate according to claim 25 wherein said urethane-coated support and said ionomer layer further comprise photoinitiator.

## Patentansprüche

1. Vorpolymer, umfassend Segmente der Struktur: 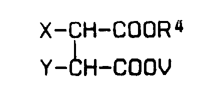 worin X und Y voneinander verschieden sind und H oder ein Kohlenstoffatom des Ausgangspolymers sind; wobei das Ausgangspolymer Polybutadien oder ein Butadiencopolymer ist;
V ist H oder M;
R⁴ ist R oder 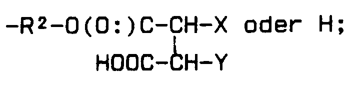
R ist -(CH₂)ₙ-OC(:O)C(R¹)=CH₂;
R¹ ist H oder Methyl;
R² ist 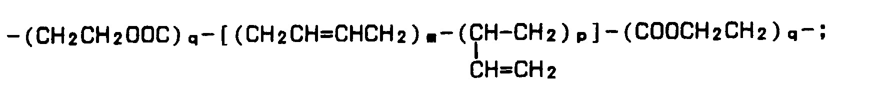
M ist Li, Na oder K;
n ist 2, 3 oder 4;
m + p = 15-130; und m ist 70-100% von m + p;
q ist 0 oder 1;
vorausgesetzt, daß in zumindest einem Segment R⁴ gleich R;
in zumindest einem Segment R⁴ ist 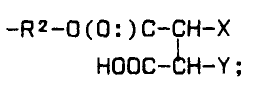 in zumindest einem Segment R⁴ ist H; und
in zumindest einem Segment V ist M.

2. Vorpolymer nach Anspruch 1, worin V gleich H.

3. Vorpolymer nach Anspruch 1, worin V gleich H oder M, vorausgesetzt, daß in zumindest einem Segment V gleich M.

4. Vorpolymer nach einem der Ansprüche 1 bis 3, worin die Segmente von einem Polybutadienmalein-Anhydrid-Addukt stammen, worin dieser Addukt ein Polybutadien mit einem Molekulargewicht von etwa 8.000 und mit etwa 8 Anhydridgruppen pro Molekül ist.

5. Vorpolymer nach Anspruch 4, worin dieser Addukt hergestellt wurde mit einem Maleinanhydrid der Formel 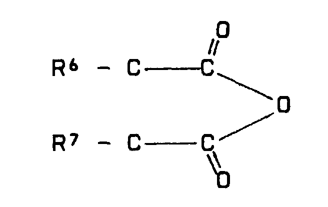 worin R⁶ und R⁷, die gleich oder verschieden sein können, jeweils für Wasserstoff, Halogen, Carboxyl, lineares oder cyclisches Alkyl mit 1-20 Kohlenstoffatomen, oder Aryl, Alkaryl oder Aralkyl mit 6 bis 20 Kohlenstoffatomen stehen.

6. Vorpolymer nach einem der vorangegangenen Ansprüche, worin das Ausgangspolymer ein Polybutadien ist, umfassend zu mindestens 70% eine 1,4-Mikrostruktur.

7. Vorpolymer nach einem der vorangegangenen Ansprüche mit einem mittleren Molekulargewicht von mindestens 15.000 und worin das Ausgangspolymer ein Polybutadien ist.

8. Vorpolymer nach Anspruch 1, worin n=2 und R¹ Methyl ist.

9. Vorpolymer nach Anspruch 3, worin n 2 ist; R¹ Methyl ist; m etwa 70 ist, p etwa 23 ist, q 1 ist und das Molekulargewicht des Ausgangspolymers etwa 8000 ist.

10. Photohärtbare Zusammensetzung, umfassend ein Vorpolymer nach einem der Ansprüche 1 bis 9 und weiterhin umfassend ein ungesättigtes Monomer.

11. Photohärtbare Zusammensetzung nach Anspruch 10, worin dieses ungesättigte Monomer ein Methacrylat oder Acrylat ist.

12. Photohärtbare Zusammensetzung nach Anspruch 10 oder 11, welche ferner einen Photoinitiator umfaßt.

13. Flexibler, photoempfindlicher Gegenstand, umfassend einen Träger und eine feste, lichtempfindliche Schicht, welche eine photohärtbare Zusammensetzung enthält, wie in einem der Ansprüche 10 bis 12 definiert.

14. Verfahren zur Herstellung eines wässrigen, dispergierbaren, photohärtbaren Vorpolymers für einen flexiblen lichtempfindlichen Gegenstand, welches Verfahren umfaßt
a) Umsetzen von Anhydridgruppen eines Malein-Anhydrid-Addukts eines Polybutadien- oder Butadien-Copolymers mit einem Reagenz mit olefinisch ungesättigten Gruppen und einer Anhydrid-reaktiven funktionellen Gruppe, wobei bei der Reaktion die Anhydridgruppen geöffnet und Carboxylsäuregruppen gebildet werden;
b) Kettenverlängern bei dem Addukts aus a) durch Umsetzen eines polymeren Alkadienpolyols der Struktur [R²]-[OH]_{w}, worin w = 2-3 und R² wie in Anspruch 1 definiert ist, mit nichtumgesetzten Anhydridgruppen des Reaktionsprodukts von a) derart, daß das Molekulargewicht (Mn) des kettenverlängerten Polymers mindestens 2500 beträgt; und
c) Umsetzen der nach den Schritten a) und b) verbliebenen Anhydridgruppen mit Wasser zur Bildung von Carboxylsäuregruppen; und, wahlweise,
d) Neutralisieren zumindest eines Teils der Carboxylsäuregruppen aus c) mit einer Li-, Na- oder K-haltigen Base.

15. Verfahren nach Anspruch 14, worin, bezogen auf 100 Gewichtsanteile des Malein-Anhydrid-Addukts von Polybutadien- oder Butadien-Copolymer, das Verfahren, in Gewichtsanteilen, umfaßt:
1) 5-30 Teile der Anhydridgruppen des Addukts;
2) 0,7-3,2 Teile des Reagenz aus Schritt a); und
3) 10-63 Teile des polymeren Alkadienpolyols.

16. Verfahren nach Anspruch 14 oder 15, welches umfaßt:
1) 8-20 Teile der Anhydridgruppen;
2) 2,0-2,6 Teile des Reagenz aus Schritt a); und
3) 30-50 Teile des polymeren Alkadienpolyols.

17. Verfahren nach Anspruch 14, 15 oder 16, worin 40-100 Mol-% der Carboxylsäuregruppen aus c) neutralisiert sind.

18. Verfahren nach Anspruch 17, worin 50-70 Mol-% der Carboxylsäuregruppen aus c) neutralisiert sind.

19. Verfahren nach einem der Ansprüche 14 bis 18, worin das Reaktionsprodukt aus c) auf einen Träger gegossen wird oder das neutralisierte Produkt aus Schritt d) auf einen Träger gegossen oder extrudiert wird.

20. Verfahren nach einem der Ansprüche 14 bis 19, worin dieser Addukt aus einem Polybutadien mit einem Molekulargewicht von etwa 8000 und zu etwa 70% einer 1,4-Mikrostruktur hergestellt wird und dieser Addukt etwa 8 Anhydridgruppen pro Molekül aufweist.

21. Verfahren nach einem der Ansprüche 14 bis 20, worin in b) das polymere Alkadienpolyol ein Diol ist, worin m etwa 70% von m + p ist und p etwa 23 ist.

22. Verfahren nach einem der Ansprüche 14 bis 21, worin das Reagenz aus Schritt a) HO-(CH₂)ₙ-O-C(:O)-C(R¹)=CH₂ ist, worin R¹ Wasserstoff oder Methyl ist, und n = 2 bis 4.

23. Verfahren nach einem der Ansprüche 14 bis 22, welches ferner das Mischen des neutralisierten Reaktionsprodukts mit ungesättigten Monomeren und Photoinitiatoren umfaßt.

24. Verfahren zur Herstellung einer Flexodruckplatte, welches Verfahren umfaßt:
1) überziehen eines Urethan-beschichteten Trägers mit einem nicht-ionomeren Polymer, umfassend Segmente der Struktur 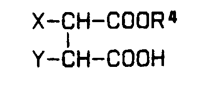 und
2) Aufbringen auf den Überzug aus 1) einer Schicht eines Ionomers, umfassend Segmente der Struktur: 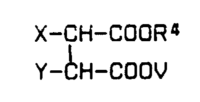 worin die verschiedenen Symbole wie in Anspruch 1 definiert sind.

25. Druckplatte, zu erhalten durch das Verfahren nach Anspruch 24, worin dieser Urethan-beschichtete Träger und diese Ionomerschicht ferner ungesättigtes Monomer umfassen.

26. Druckplatte nach Anspruch 25, worin dieser Urethan-beschichtete Träger und diese Ionomerschicht ferner Photoinitiator umfassen.

## Revendications

1. Prépolymère comprenant des segments de structure : 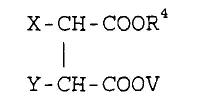 dans laquelle X et Y sont différents et sont H ou un atome de carbone du polymère de base ; le polymère de base étant un polybutadiène ou un copolymère de butadiène ;
V est H ou M ;
R⁴ est R ou 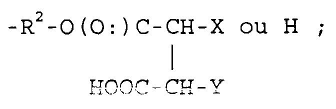 ou H ;
R est -(CH₂)ₙ-OC(:O)C(R¹)=CH₂;
R¹ est H ou le groupe méthyle ;
R² est 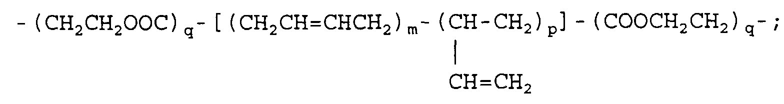
M est Li, Na ou K ;
n vaut 2, 3 ou 4 ;
m + p = 15 à 130 ; et m représente 70 à 100 % de m + p ;
q vaut 0 ou 1 ;
du moment que, dans au moins un segment, R⁴ est R ;
dans au moins un segment, R⁴ est 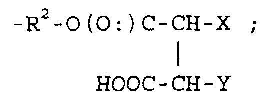 dans au moins un segment, R⁴ est H ; et
dans au moins un segment, V est M.

2. Prépolymère selon la revendication 1, dans lequel V est H.

3. Prépolymère selon la revendication 1, dans lequel V est H ou M, du moment que, dans au moins un segment, V est M.

4. Prépolymère selon l'une quelconque des revendications 1 à 3, dans lequel les segments dérivent d'un produit d'addition d'anhydride maléique et de polybutadiène, dans lequel ledit produit d'addition est un polybutadiène ayant une masse moléculaire d'environ 8000 et ayant environ 8 groupes anhydride par molécule.

5. Prépolymère selon la revendication 4, dans lequel ledit produit d'addition est préparé avec un anhydride maléique de formule : 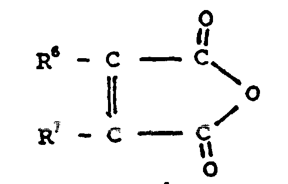 dans laquelle R⁶ et R⁷, qui peuvent être identiques ou différents, représentent chacun l'hydrogène, un halogène, un groupe carboxyle, un groupe alkyle linéaire ou cyclique contenant de 1 à 20 atomes de carbone, ou un groupe aryle, alcaryle ou aralkyle contenant de 6 à 20 atomes de carbone.

6. Prépolymère selon l'une quelconque des revendications précédentes, dans lequel le polymère de base est un polybutadiène constitué au moins à 70 % de microstructure 1,4.

7. Prépolymère selon l'une quelconque des revendications précédentes, ayant une masse moléculaire moyenne d'au moins 15.000, et dans lequel le polymère de base est un polybutadiène.

8. Prépolymère selon la revendication 1, dans lequel n vaut 2 et R¹ est le radical méthyle.

9. Prépolymère selon la revendication 3, dans lequel n vaut 2, R¹ est le radical méthyle, m vaut environ 70, p vaut environ 23, q vaut 1, et la masse moléculaire du polymère de base est d'environ 8000.

10. Composition photodurcissable, comprenant un prépolymère selon l'une quelconque des revendications 1 à 9 et comprenant en outre un monomère insaturé.

11. Composition photodurcissable selon la revendication 10, dans laquelle ledit monomère insaturé est un méthacrylate ou un acrylate.

12. Composition photodurcissable selon la revendication 10 ou 11, comprenant en outre un photoamorceur.

13. Article photosensible flexible, comprenant un support et une couche photosensible solide comprenant une composition photodurcissable telle que définie dans l'une quelconque des revendications 10 à 12.

14. Procédé pour la préparation d'un prépolymère photodurcissable dispersible en solution aqueuse pour un article photosensible, le procédé comprenant :
(a) la réaction de groupes anhydride d'un produit d'addition d'anhydride maléique et d'un polybutadiène ou d'un copolymère de butadiène, avec un réactif ayant des groupes à insaturation oléfinique et un groupe anhydride fonctionnel réactif, dans laquelle, lors de la réaction, les groupes anhydride sont ouverts et des groupes acide carboxylique sont formés ;
(b) l'allongement de chaîne du produit d'addition de (a) par réaction d'un polyalcadiène polyol ayant la structure [R²]-OH_{w} où w = 2-3 et R² est tel que défini dans la revendication 1, avec des groupes anhydride n'ayant pas réagi du produit de réaction de (a), de façon que la masse moléculaire (Mₙ) du polymère à chaîne allongée soit d'au moins 2500 ; et
(c) la réaction des groupes anhydride restants après les étapes (a) et (b), avec de l'eau pour former des groupes acide carboxylique ; et, éventuellement,
(d) la neutralisation d'au moins une partie des groupes acide carboxylique dans (c) avec une base contenant Li, Na ou K.

15. Procédé selon la revendication 14, dans lequel, pour 100 parties en poids de produit d'addition d'anhydride maléique et de polybutadiène ou de copolymère de butadiène, le procédé comprend, en parties en poids :
(1) 5 à 30 parties des groupes anhydride du produit d'addition ;
(2) 0,7 à 3,2 parties du réactif dans l'étape (a) ; et
(3) 10 à 63 parties du polyalcadiène polyol.

16. Procédé selon la revendication 14 ou 15, comprenant :
(1) 8 à 20 parties des groupes anhydride ;
(2) 2,0 à 2,6 parties du réactif dans l'étape (a) ; et
(3) 30 à 50 parties du polyalcadiène polyol.

17. Procédé selon la revendication 14, 15 ou 16, dans lequel 40 à 100 % en moles des groupes acide carboxylique dans l'étape (c) sont neutralisés.

18. Procédé selon la revendication 17, dans lequel 50 à 70 % en moles des groupes acide carboxylique dans l'étape (c) sont neutralisés.

19. Procédé selon l'une quelconque des revendications 14 à 18, dans lequel le produit de réaction dans l'étape (c) est déposé sur un support, ou bien le produit neutralisé de l'étape (d) est déposé ou extrudé sur un support.

20. Procédé selon l'une quelconque des revendications 14 à 19, dans lequel ledit produit d'addition est préparé à partir d'un polybutadiène ayant une masse moléculaire d'environ 8000 et constitué à environ 70 % de microstructure 1,4, et ledit produit d'addition a environ 8 groupes anhydride par molécule.

21. Procédé selon l'une quelconque des revendications 14 à 20, dans lequel, dans l'étape (b), le polyalcadiène polyol est un diol dans lequel m représente environ 70 % de m + p, et p vaut environ 23.

22. Procédé selon l'une quelconque des revendications 14 à 21, dans lequel le réactif dans l'étape (a) est HO-(CH₂)ₙ-O-C(:O)-C(R¹)=CH₂ où R¹ est l'hydrogène ou un groupe méthyle et n = 2 à 4.

23. Procédé selon l'une quelconque des revendications 14 à 22, comprenant en outre le mélange du produit de réaction neutralisé avec des monomères insaturés et des photoamorceurs.

24. Procédé pour former une plaque d'impression flexographique, ce procédé comprenant :
(1) le revêtement d'un support revêtu d'uréthanne avec un polymère non ionomère comprenant des segments de structure : 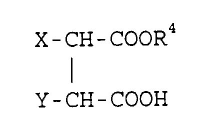 et
(2) l'application sur le revêtement de (1) d'une couche d'un ionomère comprenant des segments de structure : 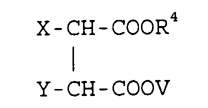 dans laquelle les divers symboles sont tels que définis dans la revendication 1.

25. Plaque d'impression pouvant être obtenue par le procédé de la revendication 24, dans laquelle ledit support revêtu d'uréthanne et ladite couche d'ionomère comprennent de plus un monomère insaturé.

26. Plaque d'impression selon la revendication 25, dans laquelle ledit support revêtu d'uréthanne et ladite couche d'ionomère comprennent de plus un photoamorceur.
